(19) Europäisches Patentamt
European Patent Office
Office européen des brevets

(11) **EP 2 482 335 A2**

(12) **EUROPÄISCHE PATENTANMELDUNG**

(43) Veröffentlichungstag:
**01.08.2012 Patentblatt 2012/31**

(21) Anmeldenummer: **12000291.0**

(22) Anmeldetag: **19.01.2012**

(51) Int Cl.:
*H01L 31/048* (2006.01)   *C08J 5/18* (2006.01)
*C08L 67/02* (2006.01)   *B29C 55/02* (2006.01)
*B29C 55/14* (2006.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **31.01.2011 DE 102011009818**

(71) Anmelder: **Mitsubishi Polyester Film GmbH**
**65203 Wiesbaden (DE)**

(72) Erfinder:
• **Kliesch, Holger, Dr.**
**65462 Ginsheim-Gustavsburg (DE)**
• **Klein, Oliver, Dr.**
**55437 Ockenheim (DE)**
• **Konrad, Matthias, Dr.**
**65830 Kriftel (DE)**
• **Kuhmann, Bodo**
**65594 Runkel (DE)**

(74) Vertreter: **Schweitzer, Klaus et al**
**Plate Schweitzer Zounek**
**Patentanwälte**
**Rheingaustrasse 196**
**65203 Wiesbaden (DE)**

(54) **Weisse biaxial gestreckte Polyesterfolie mit hohem Cyclohexandimethanolanteil und einem primären und sekundären Dicarbonsäureanteil sowie ein Verfahren zu ihrer Herstellung und ihre Verwendung**

(57)     Die Erfindung betrifft eine weiße, biaxial gestreckte Folie, überwiegend bestehend aus einem Polyester, dessen Diolkomponente zu mindestens 80 Mol-% aus 1,4-Cyclohexandimethanol (CHDM) besteht und dessen Dicarbonsäurekomponente zu mindestens 80 Mol-% aus einer oder mehreren Benzoldicarbonsäure(n) oder/und einer oder mehreren Naphthalindicarbonsäure(n) besteht, die Dicarbonsäurekomponente aus einer Hauptdicarbonsäurekomponente mit mindestens 55 Mol-% Anteil besteht, die ausgewählt ist aus einer der beiden Dicarbonsäuren 2,6-Naphthalindicarbonsäure und Terephthalsäure, und aus einer Nebendicarbonsäurekomponente mit mindestens 18 Mol-% Anteil besteht, wobei die Nebendicarbonsäurekomponente verschieden ist von der Hauptdicarbonsäurekomponente. Außerdem betrifft die Erfindung ein Verfahren zur Herstellung der Folie sowie ihre Verwendung.

**Beschreibung**

Die Erfindung betrifft eine weiße biaxial gestreckte Folie aus einem Polyester, deren Dicke bevorzugt im Bereich von 12 bis 600 μm liegt. Die Folie besteht überwiegend aus einem Polyester, dessen Diolkomponente im Wesentlichen aus Cyclohexandimethanol besteht. Die Dicarbonsäurekomponete besteht zu einem erheblichen (= hauptsächlichen) Teil aus einer Benzol - oder Naphthalindicarbonsäure, wobei jedoch mindestens 18 Mol-% der Dicarbonsäurekomponente aus einer anderen Dicarbonsäure als der hauptsächlich verwendeten Benzoldicarbonsäure oder Naphthalindicabonsäure bestehen. Die Folie enthält weiterhin mindestens 1 Gew.-% eines Weißpigmentes oder (mit Polyester) unverträglichen Polymers zur Weißfärbung. Diese Folien zeichnen sich durch ihre gute Herstellbarkeit, eine sehr gute Hydrolysebeständigkeit und gute Elektroisoliereigenschaften aus. Die Erfindung betrifft ferner ein Verfahren zur Herstellung der Folie sowie ihre Verwendung.

Biaxial gestreckte Folien aus Polyestern im angegebenen Dickenbereich sind hinreichend bekannt.

In Elektroisolieranwendungen wie Kabeln, Motorisolierung oder Folie für Rückseitenlaminate von Solarmodulen werden in der Regel relativ lange Lebensdauern von mehreren Jahren zum Teil unter Anwendungstemperaturen gefordert, die in die Region der Glastemperatur von des in der industriellen Praxis hauptsächlich verwendeten Polyesters, PET = Polyethylenterephthalat, von ca. 78 °C kommen. Unter diesen Bedingungen wird die Hydrolyseneigung der Polyester eine kritische Größe für die Lebensdauer in der Anwendung. Zwar sind Einflussgrößen wie ein niedriger Carboxylendgruppengehalt (CEG content) auf die Hydrolysegeschwindigkeit schon sehr lange bekannt (z. B. US-A-3,051,212); die in der industriellen Praxis angewandten Verfahren zur Herstellung von Polyestern mit niedrigem Carboxylendgruppengehalt bedingen jedoch akribische Prozesskontrolle und anschließende Festphasenpolymerisation.

Ein Nachteil solcher Rohstoffe zeigt sich insbesondere dann, wenn - wie dies für die kommerzielle Herstellung von Polyesterfolien aus wirtschaftlichen Gründen unabdingbar ist - die Produktionsabfälle (auch Rezyklat oder (Eigen) Regenerat genannt) aus der Folienproduktion zu einem möglichst hohen Anteil wieder in ebendiese Folienproduktion zurückgeführt werden. Bei der Herstellung von biaxial gestreckten Polyesterfolien werden prozessbedingt im Regelfall 1,5 - 2,5 kg Rohstoff für ein kg Folie benötigt. Der Rest (0,5 -1,5 kg/kg Folie) fällt in Form von Randstreifen und Folienverschnitt an, der gehäckselt und anschließend direkt wiedereingesetzt wird oder extrudiert und regranuliert wird und dann wiedereingesetzt wird (Rezyklat, (Eigen)Regenerat). Bei der Folienherstellung und erst recht bei der späteren erneuten Extrusion zur Regeneratherstellung steigt der Carboxylendgruppengehalt aber stark an und beschränkt so den Wiedereinsatz von Regenerat bis hin zum notwendigen völligen Verzicht auf dieses. Die Reduzierung der Hydrolysegeschwindigkeit beispielsweise durch Einstellen eines niedrigen Carboxylendgruppengehalts des Polyesters ist in ihrer Wirkung jedoch beschränkt und ohne weitere komplexe Additivsysteme sind die resultierenden Folien für viele Anwendungen, wie Rückseitenlaminate in Solarmodulen, immer noch nicht ausreichend hydrolysestabilisiert.

Durch die Wahl anderer Monomere als Ethylenglykol und Terephthalsäure kann die Hydrolysegeschwindigkeit ebenfalls deutlich reduziert werden. Aus Polyethylennaphthalat (PEN) mit Naphthalindicarbonsäure als Monomer an Stelle von Terephthalsäure können Folien mit sehr deutlich reduzierter Hydrolysegeschwindigkeit erhalten werden, die aber in ihrer Anwendbarkeit sowohl durch den hohen Rohstoffpreis (ca. Faktor 5 gegenüber PET) als auch durch die deutlich schwierigere Herstellung biaxial gestreckter Folien (u. a. verursacht durch die stark erhöhte Glastemperatur von ca. 120 - 125 °C) beschränkt sind. Zudem muss z. B. im Rückseitenlaminat eines Solarmoduls eine Verbindung zu anderen Folien aus anderen Polymeren (Polyester, EVA u. a.) hergestellt werden. Die relativ inerte Natur von PEN macht die Herstellung solcher Laminate schwieriger als bei Verwendung anderer Polyester.

PCT = Poly(1,4-Cyclohexan-Dimethylen)-terephthalat ist ebenfalls als hydrolysestabiler Polyester bekannt, kommt aber in biaxial gestreckten Folien in der Praxis nicht zum Einsatz. Der Grund liegt in der Sprödigkeit des Materials, insbesondere nach der zur Schrumpfreduktion nötigen Hitzefixierung der biaxial gestreckten Folien. Daher kommt PCT zumeist als PETG (= PET mit Cyclohexandimethanol [CHDM] + Ethylenglykol [EG] als Diol-Monomereinheiten, zumeist mit mehr als 50 Mol-% EG) auf den Markt. PETG ist aber nicht mehr hydrolysestabil, so dass es sich für die Zielanwendungen (Elektroisolation insbesondere in Solarmodulen) nicht mehr eignet.

In Rückseitenlaminaten für Solarmodule sollte mindestens die äußerste Laminatlage, idealerweise das gesamte Laminat, eine so hohe Hydrolysestabilität aufweisen, dass auch nach 25 Jahren im Außeneinsatz eine genügende Isolation vorhanden ist. Zurzeit wird dies in der Regel durch Laminate aus Polyvinylfluorid (PVF) (z. B. Tedlar®, DuPont) und PET gelöst, bei denen mindestens die Laminat-Außenseite aus Tedlar besteht und zumeist das PET als isolierende Mittellage zwischen zwei Tedlarlagen liegt. Tedlar und andere Fluorpolymere sind aber teuer und werden in der Zukunft mit der stark wachsenden Zahl von Solarmodulen, die das Ende ihres Einsatzzeitraumes erreichen, auch zu einem starken Recyclingproblem werden, da sie weder einfach in sich selbst regeneriert noch schadstoffarm entsorgt (z. B. verbrannt) werden können.

Ziel der vorliegenden Erfindung war es, eine weiße Polyesterfolie in der bevorzugten Dicke von 12 - 600 μm bereitzustellen, die die genannten Nachteile des Standes der Technik vermeidet, sich kostengünstig herstellen lässt und sich durch gute Elektroisoliereigenschaften, insbesondere im Einsatz als Rückseitenlaminat von Solarmodulen, auszeichnet und somit zur allgemeinen Verwendung in Elektroisolieranwendungen geeignet ist.

Erreicht wird dies durch eine biaxial gestreckte (= orientierte) Folie, die überwiegend aus einem Polyester besteht, dessen Diolkomponente zu mindestens 80 Mol-%, bevorzugt zu mindestens 95 Mol-% und besonders bevorzugt zu mindestens 99 Mol-%, aus 1,4-Cyclohexandimethanol (CHDM) besteht. CHDM kann sowohl als Cis-Isomer c-CHDM, Trans-Isomer t-CHDM oder als Mischung c/t-CHDM vorhanden sein. Unter "Diolkomponente" wird erfindungsgemäß die von einem Diol abgeleitete Struktur verstanden, die in die Polyesterkette eingebaut ist; die abgeleitete Struktur trägt dabei den Namen der monomeren Verbindung, wobei der Name der monomeren Verbindung als solche hier gegebenenfalls auch alternativ und gleichwertig anstelle der Komponente verwendet wird. Je höher der Cyclohexandimethanolanteil, desto höher ist auch die Hydrolysebeständigkeit. Die Dicarbonsäurekomponente des Polyesters besteht zu mindestens 80 Mol-% aus einer Benzoldicarbonsäure oder/und einer Naphthalindicarbonsäure (= NDC), bevorzugt zu mindestens 95 Mol-% und besonders bevorzugt zu mindestens 99 Mol-% aus einer Benzoldicarbonsäure oder/und einer Naphthalindicarbonsäure. Unter "Dicarbonsäurekomponente" wird erfindungsgemäß die von einer Dicarbonsäure abgeleitete Struktur verstanden, die in die Polyesterkette eingebaut ist; die abgeleitete Struktur trägt dabei den Namen der monomeren Verbindung, wobei der Name der monomeren Verbindung als solche hier gegebenenfalls auch alternativ und gleichwertig anstelle der Komponente verwendet wird. Bevorzugt besteht die Dicarbonsäurekomponente in den oben angegebenen Mengen aus einer Benzoldicarbonsäure. Die bevorzugte Naphthalindicarbonsäure ist 2,6-Naphthalindicarbonsäure (2,6-NDC) und die bevorzugte Benzoldicarbonsäure ist Terephthalsäure (= TA).

In einer besonders bevorzugten Ausgestaltung mit guter Hydrolysestabilität besteht die Dicarbonsäurekomponente zu mindestens 55 Mol-% (= hauptsächlich verwendete Dicarbonsäurekomponente), bevorzugt zu mindestens 60 und besonders bevorzugt zu mindestens 64 Mol-%, aus einer der beiden bevorzugten Dicarbonsäuren und besonders bevorzugt aus Terephthalsäure.

Neben der hauptsächlich verwendeten Dicarbonsäure ($\geq$ 55 Mol-%) liegen immer mindestens 18 Mol-% mindestens einer anderen als der hauptsächlich verwendeten Dicarbonsäure vor. Dies kann z. B. 2,6-Naphthalindicarbonsäure sein, wenn die Hauptkomponente Terephthalsäure ist, und umgekehrt. In einer besonders bevorzugten Ausführungsform mit guter Hydrolysestabilität und guter Herstellbarkeit (geringe Sprödigkeit) enthält der Polyester mindestens 18,0 Mol-% Isophthalsäure (IPA) und bevorzugt mindestens 20 Mol-% Isophthalsäure und besonders bevorzugt mindestens 25 Mol-% Isophthalsäure als weitere Dicarbonsäurekomponente (Mol-% bezogen auf die Gesamtheit der Dicarbonsäurekomponenten). Je höher der Anteil an Isophthalsäure ist, desto besser lässt sich die Folie wirtschaftlich herstellen, da die Anzahl der Abrisse sinkt und die Randsprödigkeit abnimmt. Unterhalb von 18,0 Mol-% IPA war die Produktivität aufgrund der oben genannten Faktoren unbefriedigend. Oberhalb von 25 Mol-% konnte eine mit Standard-PET vergleichbare Produktivität erreicht werden. Der Anteil an Isophthalsäure sollte nicht über 40 Mol-% liegen und besser nicht über 36 Mol-%, da dann die thermische und hydrolytische Stabilität der Folien deutlich abnimmt. Zwischen 18,0 und 40 Mol-% IPA lassen sich die Polyester zudem in für PET-Folienproduktion vorgesehenen Extrudern bei Temperaturen unterhalb von 300 °C gut aufschmelzen, und es kommt auch im Bereich der Schmelzeleitung nicht zu scherungsbedingten Temperaturanstiegen mit der Folge von Gelbildung und Produktivitätsverlust; dies tritt unterhalb von 18,0 Mol-% verstärkt auf. Oberhalb von 40 Mol-% IPA neigen die Rohstoffe zum Kleben in den Einzugszonen der Extruder und zu deutlich erhöhter Gelbildung in der Extrusion.

Die für IPA angegebenen Bereiche gelten in gleicher Weise auch für andere Dicarbonsäuren wie NDC, bevorzugt 2,6-NDC, als zweite Komponente bei TA als Hauptdicarbonsäure oder TA als zweite Komponente bei NDC, bevorzugt 2,6-NDC, als Hauptdicarbonsäure. Dies gilt auch für 1,4-Cyclohexandicarbonsäure und andere, wobei TA, NDC, bevorzugt 2,6-NDC, und IPA die bevorzugten Dicarbonsäuren sind.

Andere Dicarbonsäuren als die oben genannten Terephthalsäure, Isophthalsäure oder NDC bzw. 2,6-NDC wie weitere aromatische, aber auch aliphatische Dicarbonsäuren können ebenfalls enthalten sein, führen aber in aller Regel zu einer Verschlechterung der Herstellungseigenschaften oder/und der thermischen und hydrolytischen Stabilität. Daher liegt ihr Anteil - sofern überhaupt vorhanden - bevorzugt unter 10 Mol-% und idealerweise unter 1 Mol-%.

Wie oben beschrieben, ist TA die am meisten bevorzugte Dicarbonsäure. In einer bevorzugten Ausführungsform liegt neben TA mindestens 5 Mol-%, bevorzugt mindestens 10 Mol-%, NDC ,bevorzugt 2,6-NDC, vor, wobei mehr als 25 Mol-% weniger bevorzugt sind und idealerweise 21 Mol-% NDC bzw. 2,6-NDC nicht überschritten werden sollten. Neben TA und NDC, bevorzugt 2,6-NDC, liegt in einer besonders bevorzugten Ausführungsform dann noch IPA in den oben beschriebenen Mengen vor. Je höher der Anteil an NDC bzw. 2,6-NDC, desto höher die mechanische Festigkeit der resultierenden Folien. Ein steigender NDC/2,6-NDC-Gehalt wirkt sich weiterhin positiv auf die Hydrolysebeständigkeit aus. Mit steigendem NDC/2,6-NDC-Gehalt steigen aber auch die Rohmaterialkosten und die Herstellbarkeit wird schwieriger.

Die genannten Polyester können - sofern sie nicht kommerziell erhältlich sind - beispielsweise nach dem an sich bekannten DMT-Verfahren oder nach dem TPA-Verfahren hergestellt werden, wie es weiter unten bei der Beschreibung der Herstellung der Masterbatche näher erläutert ist. Dabei werden die entsprechenden Diole und Dicarbonsäuren (TPA-Verfahren) bzw. deren Niedrigalkylester (DMT-Verfahren) in den genannten molaren Mengen umgesetzt.

Die Folie enthält als Hauptbestandteil einen Polyester. Die Folie besteht bevorzugt zu mindesten 70 Gew.-% und besonders bevorzugt zu 95 Gew.-% aus einem Polyester, wobei anorganische Füllstoffe vernachlässigt werden.

Die verbleibenden höchstens 30 Gew.-% können andere Polymere wie Polypropylen oder andere organische Füllstoffe wie UV-Stabilisatoren oder Flammschutzmittel sein (die Gew.-% beziehen sich auf die Masse der Gesamtfolie, wobei anorganische Füllstoffe vernachlässigt werden).

Die zuvor genannten Polyester können neben den oben genannten Hauptmonomeren weitere Monomere enthalten. Weitere Diole sind z. B. Ethylenglykol (EG), Propylenglykol (PG), 1,4-Butandiol, Diethylenglykol (DEG), Neopentylglykol und andere. Der Anteil anderer Diole als CHDM ist kleiner oder gleich 20 Mol-%, bevorzugt kleiner oder gleich 5 Mol-% und idealerweise kleiner oder gleich 1 Mol-%. Je höher der Cyclohexandimethanolanteil, desto höher ist auch die Hydrolysebeständigkeit.

Die Folie gemäß der Erfindung kann weiterhin anorganische oder organische Partikel, die zur Einstellung der Oberflächentopographie, Optik (Glanz, Trübung usw.) oder Verbesserung der Laufsicherheit und Wickelbarkeit benötigt werden, enthalten. Solche Partikel sind z. B. Kalziumcarbonat, Apatit, Siliziumdioxid, Titandioxid, Aluminiumoxid, vernetztes Polystyrol, vernetztes Polymethylmethacrylat (PMMA), Zeolithe und andere Silikate wie Aluminiumsilikate. Diese Verbindungen werden im Allgemeinen in Mengen von 0,05 bis 5 Gew.-%, vorzugsweise 0,1 bis 0,6 Gew.-%, (bezogen auf das Gewicht der Folie) eingesetzt. Besonders bevorzugt sind dabei Kalziumcarbonat und Siliziumdioxid.

Die eingesetzten Teilchengrößen $d_{50}$ liegen zum Erreichen einer guten Laufsicherheit in der Produktion im Allgemeinen zwischen 0,1 und 8 $\mu$m und bevorzugt zwischen 0,3 und 5,5 $\mu$m und besonders bevorzugt zwischen 0,5 und 2,5 $\mu$m. Faserförmige anorganische Zuschlagstoffe wie Glasfasern sind ungeeignet, da sie die Produktion der Polyesterfolie durch viele Abrisse unwirtschaftlich machen. Je geringer der $d_{50}$-Wert der eingesetzten Partikel (dies gilt auch für die nachfolgend beschriebenen Weißpigmente), desto höher wird die Teilentladungsfestigkeit (s. u.). Werden Partikel mit einem $d_{50}$ von oberhalb 8 $\mu$m eingesetzt, so können die bevorzugten Teilentladungsfestigkeiten nicht mehr sicher erreicht werden.

In der erfindungsgemäßen Ausführungsform ist die Folie weiß.

Dies bedeutet, dass die erfindungsgemäßen Folien mindestens einseitig einen Weißgrad nach Berger von mindestens 40 aufweisen. Bevorzugt liegt der Weißgrad bei > 55 und besonders bevorzugt bei > 60 und ganz besonders bevorzugt bei > 85. Wird neben dem Weißpigment ein optischer Aufheller verwendet, so liegt der Weißgrad nach Berger bei mindestens 60.

Die Weißpigmente können identisch mit den oben genannten Partikeln zur Verbesserung der Wickelbarkeit sein, müssen dann aber in ausreichender Menge und Partikelgröße zugegeben werden, um eine Weißfärbung zu erzielen. Als Weißpigment eignen sich insbesondere Titandioxid, Bariumsulfat, Zinkoxid, Kalziumkarbonat oder inkompatible Polymere wie Polypropylen, Polyethylen oder Cycloolefincopolymere (COCs) oder Kombinationen daraus. Diese werden dem Polyester zu 1 - 30 Gew.-% zugegeben, wobei die bevorzugte Zugabemenge zwischen 2 und 20 Gew.-% (bezogen auf das Gesamtgewicht der Folie) liegt. Besonders bevorzugt enthält die Folie in dieser Ausführungsform zwischen 3 und 10 Gew.-% (bezogen auf das Gesamtgewicht der Folie) an Weißpigment. Mehr Weißpigment/inkompatibles Polymer führt zu einer besseren Lichtreflektion und zu einem verbesserten UV-Schutz, führt aber auch zu höheren Kosten durch das Weißpigment/Polymere und verringert ab etwa 10 Gew.-% Anteil die Bruchfestigkeit und führt ab etwa 20 Gew.-% zu einer erschwerten Herstellbarkeit der Folie infolge von zunehmenden Abrissen. Ab 10 und insbesondere 30 Gew.-% verschlechtern sich zudem die elektrischen Eigenschaften der Folie.

Die Teilchengrößen ($d_{50}$) der eingesetzten anorganischen Weißpigmente liegen zum Erreichen einer guten Laufsicherheit und eines guten Weißgrads im Allgemeinen zwischen 0,05 und 5 $\mu$m und bevorzugt zwischen 0,07 und 3,5 $\mu$m und idealerweise zwischen 0,1 und 2,5 $\mu$m (gilt nur für anorganische Weißpigmente; organische Pigmente schmelzen üblicherweise auf). Die bevorzugten Weißpigmente sind Bariumsulfat und Titandioxid, wobei Titandioxid besonders bevorzugt ist. Überraschenderweise führt der Einsatz von Titandioxid zu einer besseren elektrischen Durchschlagfestigkeit und zu höherer Teilentladungsfestigkeit als beim

Einsatz von Bariumsulfat oder Zinkoxid. Kalziumkarbonat alleine führt erst bei sehr hoher Konzentration zu einer ausreichenden Weißfärbung und sollte daher mit einem anderen Weißpigment kombiniert werden. Bei Verwendung von Bariumsulfat müssen in der Regel mehr als 10 Gew.-% eingesetzt werden, um gute Weißgrade und UV-Stabilitäten zu erreichen. Dies führt zu den oben beschriebenen Nachteilen. Der Zusatz von $TiO_2$ ist darüber hinaus dann besonders bevorzugt, wenn das $TiO_2$ anorganisch beschichtet und gegebenenfalls zusätzlich organisch beschichtet ist. Die bevorzugten anorganischen Beschichtungen bzw. Zuschlagstoffe zum $TiO_2$ sind dabei $SiO_2$, bevorzugt $Al_2O_3$ und besonders bevorzugt Kombinationen aus $SiO_2$ und $Al_2O_3$. Der Anteil an $SiO_2$ und $Al_2O_3$ liegt bevorzugt bei >1 Gew.-% (bezogen auf das $TiO_2$), besonders bevorzugt bei > 3 Gew.-% und idealerweise bei > 5 Gew.-%. Die hohen Anteile an anorganischen Beschichtungskomponenten sind für die UV-Stabilität der erfindungsgemäßen Folien deshalb besonders günstig, weil ein Polymer mit hohem Cyclohexandimethanol-Monomeranteil - im Gegensatz zu PET - wesentlich empfindlicher gegen oxidativen und radikalischen Angriff ist. Dieser kann durch das $TiO_2$ bei UV-Bestrahlung stark beschleunigt werden und sollte, wenn UV-Exposition in der Endanwendung vorkommt, durch geeignete Wahl beschichteter $TiO_2$-Typen reduziert werden. Die anorganische Beschichtung reduziert die katalytisch wirksame Oberfläche des $TiO_2$, die zu einer Vergilbung und Versprödung der Folie führen kann, während sich die organische Beschichtung positiv auf die Einarbeitung des $TiO_2$ in den thermoplastischen Polyester auswirkt. Geeignete $TiO_2$-Typen sind kommerziell erhältlich. Beispielhaft seien R-105 von DuPont (USA) und Rodi® von Sachtleben (Deutschland) genannt. Der Zusatz des $TiO_2$ bewirkt einerseits die Weißfärbung der Folie (wie auch bei Verwendung anderer Weißpigmente) und führt auf Grund einer erhöhten Lichtreflexion zu einer Erhöhung der elektrischen Ausbeute beim Einsatz der Folie in Backsheets von Solarmodulen und anderseits zur Verbesserung der UV-Beständigkeit der Folie bzw. des Backsheets (durch Rückreflektion des UV-Lichtes), was beim Außeneinsatz des Solarmoduls von besonderem Vorteil ist. Der mittlere Teilchendurchmesser ($d_{50}$) des $TiO_2$ liegt bevorzugt im Bereich von 0,1 bis 0,5 $\mu$m, besonders bevorzugt bei 0,15 bis 0,3 $\mu$m. Die Zusatzmenge an $TiO_2$ liegt bevorzugt bei 2 bis 25 Gew.-%, insbesondere bevorzugt bei 3 bis 12 Gew.-%, besonders bevorzugt bei 4 bis 8 Gew.-% (bezogen auf das Gesamtgewicht der Folie). Die beste Lichtreflexion und der beste UV-Schutz wird erreicht, wenn $TiO_2$ in der Rutilmodifikation benutzt wird. Wenn die Folie mehrschichtig ist, hat es sich als günstig erwiesen, wenn mindestens eine oder beide dem Licht zugewandten Aussenschichten mehr Weißpigment oder unverträgliches Polymer enthalten als die darunter liegende Schicht/Schichten. Dadurch kann die Gesamtmenge an Weißpigment in der Folie verringert werden und gleichzeitig der für die Anwendung positive Reflektionsgrad und die UV-Stabilisierung erreicht werden, ohne die oben beschriebenen Nachteile eines erhöhten Weißpigmentgehalts in Kauf nehmen zu müssen.

Die Transparenz der Folie liegt in einer bevorzugten Ausführungsform bei < 50 %, besonders bevorzugt bei < 40 % und idealerweise bei < 20 %.

Neben den erwähnten Additiven kann die Folie zusätzlich weitere Komponenten wie Flammschutzmittel (bevorzugt organische Phosphorsäureester) und/oder UV-Stabilisatoren und Thermostabilisatoren enthalten. Eine Auswahl geeigneter UV-Stabilisatoren findet sich in FR 2812299. Besonders bevorzugt sind UV-Stabilisatoren, die als UV-Absorber wirken, insbesondere auf Triazinbasis, da insbesondere diese eine ausreichende Langzeitstabilität (gefordert sind in Solarmodulen meist mehr als 20 Jahre) aufweisen, oder ein Produkt aus der HALS-Gruppe (hindered amin light stabilizers), die die oxidativ empfindlichen Polymere mit hohem Cyclohexandimethanolanteil zusätzlich schützen, zumeist ohne selbst nennenswert UV-Licht zu absorbieren. Als besonders günstig hat sich eine Kombination aus Triazin und HALS erwiesen, wobei statt des Triazins auch ein UV-Absorber aus einer anderen Produktgruppe wie z. B. Benzotriazole oder Benzophenone verwendet werden kann. UV-Stabilisatoren werden in einer bevorzugten Ausführungsform zwischen 0,1 und 5 Gew.-% zugegeben (bezogen auf das Gesamtgewicht der Schicht, der sie zugegeben werden), wobei der wirksame Mindestanteil an UV-Absorber und HALS jeweils 0,1 Gew.-% ist, so dass eine Kombination aus beiden Produkten immer zu mindestens 0,2 Gew.-% in der betreffenden Schicht führt. Bei starker UV-Exposition (direkte ungeschützte Besonnung oder indirekte Besonnung über mehrere Jahre) sollte der Anteil an UV-Absorber + HALS bei mindestens 0,5 Gew.-% in der am stärksten exponierten Schicht liegen.

Wenn die äußere Schicht einer erfindungsgemäßen Mehrschichtfolie bereits mindestens 2 Gew.-% Weißpigment oder 10 Gew.-% unverträgliches Polymer enthält und mindestens 2 $\mu$m dick ist, dann führt eine Zugabe von Stabilisator zu einer Schicht unterhalb der der Lichtquelle zugewandten Schicht nicht mehr zu einer nennenswerten Verbesserung der UV-Stabilität. Daher erfolgt bei solchen mehrschichtigen Folien eine Zugabe insbesondere in der/den Deckschicht/en; die Schicht/en unterhalb der/den Deckschicht/en enthalten dann gar keinen UV-Stabilisator oder nur über den Eintrag über Regenerat, also bevorzugt weniger als 60 % und besonders bevorzugt weniger als 30 % des Gewichtsprozentanteils an Stabilisator, der in der/den Deckschicht/en enthalten ist. Ein Beispiel für erfindungsgemäß einsetzbare Stabilisatoren aus der Gruppe der UV-Absorber ist das kommerziell erhältliche Tinuvin® 1577 (Hersteller BASF, ehemals Ciba SC, Schweiz; 2-(4,6-diphenyl-1,3,5-triazin-2-yl)-5-(hexyl)oxyphenol). Bei den Verbindungen aus der HALS-Gruppe haben sich insbesondere polymere bzw. oligomere Stabilisatoren mit einem Molekulargewicht > 500, besonders bevorzugt > 900 und idealerweise > 1300, als besonders geeignet erwiesen. Beispielhaft seien hier methylierte Reaktionsprodukte von N,N'-bis(2,2,6,6-tetramethyl-4-piperidinyl)-1,6-hexadiaminpolymeren mit Morpholin-2,4,6-trichlor-1,3,5-triazin (CAS NUMBER 193098-40-7) genannt, welche kommerziell als Cyasorb®-ZV-3529 von Cytec, USA, vertrieben werden und besonders bevorzugt im Sinne der Erfindung sind. Die polymeren und oligomeren HALS führen bei geringeren Konzentrationen als niedermolekularere Stabilisatoren zu einer effektiven Stabilisierung und führen zu Folien mit besseren elektrischen Eigenschaften.

Bei Verwendung der oben genannten Stabilisatoren in den angegebenen Mengen liegt die Transparenz der erfindungsgemäßen Folien im UV-A-Bereich bei 370 nm bei < 10 % und bevorzugt bei < 6 % und besonders bevorzugt bei kleiner 3 %.

Weiterhin hat es sich als günstig erwiesen, wenn der Folie ein Stabilisator in Form eines Radikalfängers hinzugegeben wird, da dadurch die thermische Langzeitstabilität verbessert werden kann. Zweckmäßigerweise enthält die erfindungsgemäße Folie solche Radikalfänger bzw. Thermostabilisatoren in Mengen von 50 bis 15000 ppm, bevorzugt 100 bis 5000 ppm, besonders bevorzugt 300 bis 1000 ppm, bezogen auf das Gewicht der Folie. Die üblicherweise dem Polyesterrohstoff zugegebenen Stabilisatoren werden beliebig ausgewählt aus der Gruppe der primären Stabilisatoren wie sterisch gehinderte Phenole oder sekundäre aromatische Amine oder der Gruppe der sekundären Stabilisatoren wie Thioether, Phosphite und Phosphonite sowie Zink-dibutyl-dithiocarbamat oder synergistische Mischungen aus primären und sekundären Stabilisatoren. Bevorzugt sind die phenolischen Stabilisatoren. Zu den phenolischen Stabilisatoren zählen insbesondere sterisch gehinderte Phenole, Thio-bisphenole, Alkyliden-bisphenole, Alkyl-phenole, Hydroxybenzyl-Verbindungen, Acyl-amino-phenole und Hydroxyphenylpropionate (entsprechende Verbindungen sind beispielsweise beschrieben in "Kunststoffadditive", 2. Ausgabe, Gächter Müller, Carl Hanser-Verlag, und in "Plastics Additives Handbook", 5. Ausgabe, Dr. Hans Zweifel, Carl Hanser-Verlag). Besonders bevorzugt sind die Stabilisatoren mit folgenden CAS-Nummern: 6683-19-8, 36443-68-2, 35074-77-2, 65140-91-2, 23128-74-7, 41484-35-9, 2082-79-3 sowie ®Irganox 1222 der Firma Ciba Specialities, Basel, Schweiz, wobei in besonderen Ausführungsformen die Typen ®Irganox 1010, ®Irganox 1222, ®Irganox 1330 und ®Irganox 1425 oder Mischungen daraus bevorzugt sind.

Die Folie gemäß der Erfindung wird im Allgemeinen nach an sich bekannten Extrusionsverfahren hergestellt und ist ein- oder mehrschichtig.

Die Foliendicke liegt zwischen 12 und 600 μm und bevorzugt zwischen 25 und 350 μm und besonders bevorzugt zwischen 35 und 300 μm. Unterhalb von 12 μm wird keine ausreichende elektrische Isolation für die Zielanwendungen, insbesondere Solarmodule, erreicht, und die Herstellung wird zunehmend schwieriger. Ab 300 μm nimmt die Bruchfestigkeit deutlich ab, und oberhalb von 600 μm ist diese für die Zielanwendungen zu gering.

Das/die Weißpigment/e und die andere Additive werden bevorzugt über ein Masterbatch in die entsprechende Schicht eingebracht. Zur Erstellung des Masterbatches werden bevorzugt Pigment/Additiv und Polyester in einem Mehrschneckenextruder gemischt und durch eine Lochdüse extrudiert und granuliert (= Extrusionsmasterbatch).

Das Pigment oder Additiv kann aber auch direkt bei der Polyesterherstellung zugegeben werden, um einen Masterbatch oder Batch Rohstoff herzustellen (= Polykondesationsmaterbatch). Üblicherweise werden dabei die Pigmente/Additive im Falle des DMT-Verfahrens (DMT = Dimethylterephthalat als Ausgangsmonomer) nach der Umesterung bzw. direkt vor der Polykondensation (z. B. über die Transportleitung zwischen Umesterungs- und Polykondensationskessel) als Dispersion in Cyclohexandimethanol zugegeben. Die Zugabe kann aber auch schon vor der Umesterung erfolgen. Im Falle des TPA-Verfahrens (TPA = Terephthalic Acid = Terephthalsäure als Ausgangsmonomer) erfolgt die Zugabe bevorzugt zu Beginn der Polykondensation. Eine spätere Zugabe ist jedoch auch möglich. Es hat sich bei diesem Verfahren als günstig erwiesen, wenn die Dispersion in Cyclohexandimethanol vor der Zugabe über einen PROGAF® PGF 57 (Hayward/Indiana, USA)-Filter filtriert wird.

Von den technischen Eigenschaften her, z.B. der Agglomeratbildung, bieten die Polykondensationsmasterbatche einen Vorteil. Bei kurzfristigen Anpassungen, kleinen oder variablen Batchgrößen hat der Extrusionsmasterbatch Vorteile in der Flexibilität gegenüber Polykondensationsmasterbatchen.

Ebenfalls möglich ist die Dosierung der Partikel oder Additive direkt bei der Folienherstellung in den Extruder. Dies hat jedoch häufig den Nachteil, dass die Homogenität gegenüber den anderen beiden Methoden schlechter ist und Agglomerate auftreten können, welche die Folieneigenschaften negativ beeinflussen können.

Bei dem Verfahren zur Herstellung der erfindungsgemäßen Folien wird zweckmäßigerweise so vorgegangen, dass die entsprechenden ggf. mit Pigmenten/Additiven ausgerüsteten Polymerschmelzen durch eine Flachdüse extrudiert werden, die so erhaltene Folie zur Verfestigung auf einer oder mehreren Walze/n (Kühlwalze) als weitgehend amorphe Vorfolie abgezogen und abgeschreckt wird, die Folie anschließend erneut erhitzt und biaxial gestreckt (orientiert) und die biaxial gestreckte Folie thermofixiert wird.

Es hat sich als günstig erwiesen, wenn die Temperaturen in der gesamten Extrusion 295 °C nicht überschreiten und bevorzugt 285 °C und idealerweise 280 °C nicht überschreiten, da es ansonsten zu einer deutlichen Gelbildung in der Folie kommt. Diese führt u. a. zu Abrissen im Herstellungsprozess und zu einer Verschlechterung der elektrischen Eigenschaften.

Die besten Eigenschaften hinsichtlich Hydrolysestabilität und elektrischerer Eigenschaften werden erhalten, wenn die Rohstoffe in einem Zweischneckenextruder aufgeschmolzen und extrudiert werden. Werden Einschneckenextruder benutzt, so sollten die Rohstoffe vor der Extrusion getrocknet werden. Dies erfolgt zweckmäßigerweise bei Temperaturen zwischen 110 und 155 °C für einen Zeitraum von 20 Minuten bis 1,5 Stunden. Längere Zeiten und höhere Temperaturen führen zu einem thermischen Abbau der eingesetzten Polymere.

Die biaxiale Verstreckung wird im Allgemeinen sequentiell durchgeführt. Dabei wird vorzugsweise erst in Längsrichtung (d. h. in Maschinenrichtung = MD-Richtung) und anschließend in Querrichtung (d. h. senkrecht zur Maschinenrichtung = TD-Richtung) verstreckt. Dies führt zu einer Orientierung der Molekülketten. Das Verstrecken in Längsrichtung lässt sich mit Hilfe zweier entsprechend dem angestrebten Streckverhältnis verschieden schnell laufender Walzen durchführen. Zum Querverstrecken benutzt man allgemein einen entsprechenden Kluppenrahmen.

Die Temperatur, bei der die Verstreckung durchgeführt wird, kann in einem relativ großen Bereich variieren und richtet sich nach den gewünschten Eigenschaften der Folie. Im Allgemeinen wird die Längs- und auch die Querstreckung bei $T_g$ + 5 °C bis $T_g$ + 50 °C ($T_g$ = Glastemperatur des Polymers mit der höchsten $T_g$ im verwendeten (Co-)Polyester) durchgeführt. Es hat sich dabei als günstig für die Produktivität erwiesen, wenn Temperaturen zwischen $T_g$ + 5 °C bis $T_g$ + 20 °C eingestellt werden. Je näher die Folien an der Glastemperatur gestreckt werden, desto geringer ist die im Prozess zu beobachtende Randversprödung, die zu Abrissen führen kann. Das Längsstreckverhältnis liegt allgemein im Bereich von 2,0 : 1 bis 6,0 : 1, vorzugsweise 2,7 : 1 bis 4,5 : 1. Das Querstreckverhältnis liegt allgemein im Bereich von 2,0 : 1 bis 5,0 : 1, vorzugsweise 3,1 : 1 bis 4,6 : 1, und das einer gegebenenfalls durchgeführten zweiten Längs- und Querstreckung liegt bei 1,1 : 1 bis 5,0 : 1.

Die Längsstreckung kann gegebenenfalls gleichzeitig mit der Querstreckung (Simultanstreckung) durchgeführt werden.

Bei der nachfolgenden Thermofixierung wird die Folie etwa 0,1 bis 10 s lang bei einer Temperatur von 170 bis 255 °C, vorzugsweise 210 bis 250 °C und idealerweise bei einer Temperatur von 220 bis 240 °C, gehalten. Die tatsächlich (von der Folie) erlebten Temperaturen liegen zumeist 1 - 3 °C unterhalb der im Fixierrahmen eingestellten Lufttemperaturen. Die im Fixierprozess eingestellte Temperatur (= Luft-oder Umgebungstemperatur) lässt sich an einer fertigen Folie nicht direkt messen. Sie kann an der fertigen Folie ermittelt werden, indem wie in US-A-6,737,226, Spalte 6, beschrieben die tatsächlich erlebte Fixiertemperatur bestimmt wird und zu dieser 1 bis 3 °C addiert werden. Das Resultat gibt eine Bandbreite für die im Prozess eingestellte Fixiertemperatur an.

Anschließend an die bzw. beginnend in der Thermofixierung wird die Folie gegebenenfalls um 0,5 bis 15 %, vorzugsweise um 2 bis 8 %, in Quer- und gegebenenfalls auch in Längsrichtung relaxiert und dann in üblicher Weise abgekühlt und aufgewickelt.

Zum Erreichen der gewünschten guten elektrischen Isoliereigenschaften, hat es sich als günstig erwiesen, wenn das Flächenstreckverhältnis (längs mal quer) größer ist als 5 bzw. besser größer 7 und besonders bevorzugt größer 8 ist. Das Flächenstreckverhältnis liegt in einer bevorzugten Ausführungsform unterhalb von 17. Ein Flächenstreckverhältnis oberhalb von 20 hat sich als ungünstig hinsichtlich der Laufsicherheit der Folie erwiesen, und ab einem Flächenstreckverhältnis von 24 wird es schwierig, wirtschaftlich interessante Lauflängen der Folienbahn zu erreichen.

Die genannten Flächenstreckverhältnisse führen zu Folien, die bevorzugt in jeder Folienrichtung einen E-Modul von größer 1500 N/mm$^2$ und besonders bevorzugt in jeder Folienrichtung von größer 2000 N/mm$^2$ und idealerweise in jeder Folienrichtung von größer 2300 N/mm$^2$ aufweisen und bevorzugt in keiner Folienrichtung einen E-Modul von größer 5000 N/mm$^2$ und idealerweise in keiner Folienrichtung einen E-Modul von größer 4000 N/mm$^2$ aufweisen.

Der F5-Wert (Kraft bei 5 % Dehnung) liegt bevorzugt in jeder Folienrichtung bei größer 40 N/mm$^2$ und besonders bevorzugt in jeder Folienrichtung bei größer 50 N/mm$^2$ und idealerweise in jeder Folienrichtung bei größer 60 N/mm$^2$; bevorzugt weist die Folie in keiner Folienrichtung eine Kraft bei 5 % Dehnung von größer 140 N/mm$^2$ auf.

Die Reißfestigkeit liegt bevorzugt in jeder Folienrichtung bei größer 65 N/mm$^2$ und besonders bevorzugt in jeder Folienrichtung bei größer 75 N/mm$^2$ und idealerweise in jeder Folienrichtung bei größer 85 N/mm$^2$ und liegt bevorzugt in keiner Folienrichtung bei größer 290 N/mm$^2$ und besonders bevorzugt in keiner Folienrichtung bei > 220 N/mm$^2$ und idealerweise in keiner Folienrichtung bei > 190 N/mm$^2$.

Die Einhaltung der genannten mechanischen Werte ist äußerst zweckmäßig, um die Folie in den nachgeschalteten Verarbeitungsprozessen (Schneiden, Wickeln, Laminieren, Stapeln etc.) gut handhaben zu können. Hohe mechanische Festigkeiten verhindern Verdehnungen und Falten in Folgeprozessen. Bei den genannten Obergrenzen beginnt das Risiko einer teilweisen Überstreckung (Überdehnung) der Folie im Herstellprozess, dies führt zu geringerer Bruchfestigkeit und stark schwankenden Eigenschaften in den überstreckten Bereichen. Die mechanischen Festigkeiten werden neben den Streckverhältnissen auch durch den IPA-Gehalt maßgeblich beeinflusst. Die Festigkeiten nehmen im Allgemeinen mit zunehmendem IPA-Gehalt ab, und oberhalb von 40 Mol-% IPA wird es schwierig, die bevorzugten Werte zu erreichen (die Streckverhältnisse müssen stark angehoben werden mit der Folge von vielen Abrissen im Prozess). Unterhalb von 20 Mol-% und insbesondere unterhalb von 18 Mol-% IPA steigt das Risiko von einer teilweisen Überstreckung (Überdehnung) der Folie im Herstellprozess an, wenn die gewünschten Werte erreicht werden sollen.

Die genannten Streckverhältnisse führen zudem zu Folien, die ausreichende Reißdehnungen aufweisen, um in den Rückseitenisolationen von Solarmodulen flexibel genug zu sein für die mechanischen Belastungen während der Fertigung und in der Anwendung (z. B. Windlast). Die Reißdehnung sollte in jeder Folienrichtung größer 20 % sein und liegt bevorzugt in jeder Folienrichtung größer 45 % und idealerweise größer 75 %. Für das Erreichen dieser Reißdehnungswerte hat es sich als günstig erwiesen, wenn das Flächenstreckverhältnis kleiner ist als 24 und besser kleiner ist als 17. Mit zunehmendem IPA-Gehalt steigt die Reißdehnung an.

In einer bevorzugten Ausführungsform liegt der Schrumpf der erfindungsgemäßen Folien bei 150 °C (15 min) in beiden Folienrichtungen unterhalb von 3 %, besonders bevorzugt unterhalb von 2,5 % und idealerweise in beiden Folienrichtungen unterhalb von 1,9 %. Der Schrumpf in Querrichtung liegt bevorzugt bei < 1,0 %, besonders bevorzugt bei < 0,75 % und idealerweise bei < 0,1 %. Der Schrumpf ist bevorzugt in keiner Folienrichtung < -1,0 % (entspricht 1 % Dehnung), besonders bevorzugt in keiner Folienrichtung < -0,75 % und idealerweise in keiner Folienrichtung < -0,5 %. Dies kann erreicht werden, indem die (Umgebungs- = Luft-)Temperatur in der Fixierung größer 210 °C und bevorzugt größer 220 °C und besonders bevorzugt größer 228 °C eingestellt wird. Bevorzugt liegt die Relaxation in Querrichtung oberhalb von 3 %, und bevorzugt werden mindestens 30 % dieser Relaxation bei Temperaturen unterhalb von 200 °C durchgeführt. Der niedrige Schrumpf ist insbesondere für den Einsatz in der Rückseitenisolation bzw. in Rückseitenlaminaten von Solarmodulen wichtig, da beim Laminierprozess höhere Temperaturen auftreten, die bei höheren Schrumpfwerten zu größeren Folienverlusten führen und zudem Wellen und Falten erzeugen können. Die Folie muss bei hohen Schrumpfwerten insbesondere in Querrichtung mit Überstand auf das Solarmodul laminiert werden. Beim Laminieren schrumpft die Folie dann, und etwaige danach noch bestehende Überstände müssen abgeschnitten werden. Ein deutlich negativer Schrumpf (Dehnung) führt zu Wellen und Falten auf dem Modul und damit zu erheblichen Aussortierungen von fertigen Modulen.

Die beiden wichtigsten elektrischen Eigenschaften der erfindungsgemäßen Folien sind die Spannungsfestigkeit (engl. Break Down Voltage = BDV) und die Teilentladungsfestigkeit (engl. Partial Discharge Voltage = PDV). Von besonderer Bedeutung ist vor allem die BDV.

Die erfindungsgemäßen Folien weisen eine BDV (50 Hz, 21 °C, 50 rel. Luftfeuchte, gemessen in Luft) von mindestens 40 V/$\mu$m, bevorzugt von mindestens 100 V/$\mu$m und idealerweise von mindestens 190 V/$\mu$m auf.

Die Teilentladungsfestigkeit PDV folgt der nachfolgenden Gleichung:

$$\text{PDV [V]} = x\ \text{[V/}\mu\text{m]} \bullet \text{Foliendicke [}\mu\text{m]} + y\ \text{[V]}$$

Erfindungsgemäße Folien weisen bevorzugt x-Werte von > 0,75 [V/$\mu$m] und y-Werte von > 100 [V] auf, besonders bevorzugt ist x > 1 [V/$\mu$m] und y > 200 [V], und ganz besonders bevorzugt ist x > 1,5 [V/$\mu$m] und y > 300 [V].

Diese elektrischen Eigenschaften werden erreicht, wenn die Diol- und Dicarbonsäurekomponenten der Polyester in Mol-% im erfindungsgemäßen Bereich liegen. Besonders sicher werden die elektrischen Eigenschaften erreicht, wenn die mechanischen Eigenschaften in den bevorzugten und besser in den besonders bevorzugten Bereichen liegen, insbesondere dann wenn E-Moduli und Reißfestigkeiten die genannten bevorzugten Obergrenzen nicht überschreiten. Für das Erreichen der gewünschten elektrischen Eigenschaften hat es sich zudem als günstig erwiesen, wenn eingestellte Fixiertemperaturen von 210 °C nicht unterschritten und 250 °C nicht überschritten werden.

Die Lebensdauer von polymeren elektrischen Isoliermaterialien auf Polyesterbasis wird wesentlich durch die Umweltbedingungen wie Wärme und relative Feuchte beeinflusst. Ein Versagenskriterium des Polyesters nach Alterung unter bestimmten Feuchte- und Temperaturkriterien kann sein, dass die verwendete Folie mit der Zeit brüchig und spröde wird und dann Wasser eindringen kann, welches zur negativen Beeinflussung der elektrischen Eigenschaften führt oder sogar die gewünschte Elektroisolierwirkung gefährdet. In Anwendungen, bei denen die Elektroisolierfolie zusätzlich zur mechanischen Festigkeit des Gesamtverbundes beiträgt, geht auch diese Eigenschaft nach Alterung verloren.

Ursache für das Versagen ist im Falle von Polyestern vielfach die hydrolytische Spaltung der Polyesterketten, wobei ab einer bestimmten minimalen Kettenlänge die Sprödigkeit der Folie so groß ist, dass sie mechanischen Beanspruchungen wie z. B. Dehnen oder Biegen nicht mehr standhält.

Als Maß für die Kettenlänge und damit auch für das hydrolytische Abbauverhalten bzw. die Hydrolysebeständigkeit wurde die Standardviskosität (SV) (die in Beziehung steht zu $\eta_{rel}$, s. u.) in Abhängigkeit der Alterungszeit bestimmt. Hierzu werden die Folienproben in einem Autoklav bei 110 °C und 100 % rel. Feuchte konditioniert und der SV-Wert nach regelmäßigen Zeiten geprüft.

In einer bevorzugten Ausführungsform liegt der SV-Wert vor Beginn der Messung bei oberhalb von 750, besonders bevorzugt oberhalb von 800 und idealerweise oberhalb von 850. Eine hohe Kettenlänge zu Beginn ist vorteilhaft, da sie bei gleicher Abbaugeschwindigkeit des verwendeten Polymers die Lebensdauer verlängert. Kettenlängen, die einem SV-Wert von < 600 entsprechen, sind zu vermeiden, da hiermit nur sehr kurze Lebensdauern erzielt werden können. Zu hohe Kettenlängen oberhalb eines SV-Werts von 1200 sind ebenfalls zu vermeiden, da dies zu Problemen in der Extrusion führen kann, welche die Prozessfähigkeit und damit die wirtschaftliche Nutzbarkeit negativ beeinflussen.

Als Maß für die Abbaugeschwindigkeit wird der SV-Wert gegen die Zeit im Autoklav aufgetragen und die Steigung der Ausgleichsgeraden ermittelt. Die Autoklavierungsbedingungen sind im Abschnitt Messmethoden näher erläutert. Eine bevorzugte Ausführungsform hat unter den im Abschnitt Messmethoden beschriebenen Bedingungen eine Steigung von > -3 SV-E/h (SV-E = SV-Einheit), eine besonders bevorzugte hat eine Steigung von > -2 SV-E/h, und idealerweise liegt die Steigung bei > -1 SV-E/h. Eine Steigung von < -4 SV-E/h ist in jedem Fall zu vermeiden, da die Verschlechterung der Materialeigenschaften zu schnell fortschreitet. Eine Steigung von größer oder gleich 0 ist ebenfalls problematisch, da es dann zu Materialänderungen in der Endanwendung kommt, die sich sehr stark von dem derzeitigen Standard (PET als Zwischenlagenfolie) unterscheiden und so zu Schwierigkeiten bei der Laminatstabilität führen können.

Die erfindungsgemäß guten niedrigen SV-Abbaugeschwindigkeiten werden erreicht, wenn die Diol- und Dicarbonsäurekomponenten der Polyester in Mol-% im erfindungsgemäßen Bereich liegen, wobei insbesondere ein Überschreiten der genannten Obergrenzen bei IPA und EG ungünstig ist. Die SV-Abbaugeschwindigkeiten werden weiterhin unabhängig von Vorgenanntem dadurch positiv beeinflusst, wenn die Folie gemäß den beschriebenen Prozessparametern hergestellt wird.

Folien, die das erfindungsgemäße Polymersystem enthalten, eignen sich hervorragend für Elektroisolieranwendungen, insbesondere wenn sie einer langen Einsatzdauer (Jahre) und höheren Temperaturen (> 60 °C) und Luftfeuchte (mehr als 10 % relative Luftfeuchte) ausgesetzt sind, da sie ihre guten elektrischen Eigenschaften auch unter feuchten Wärmebedingungen für lange Zeit erhalten. Solche Anwendungen sind z. B. Flachbandkabel in Automobilen, Kabel in Sitzheizungen, Motorisolation und vor allem die Rückseitenisolation in Solarmodulen. Die Folie kann dabei sowohl alleine als auch als Laminat mit anderen Folien, z. B. EVA- oder PE-Folien, eingesetzt werden.

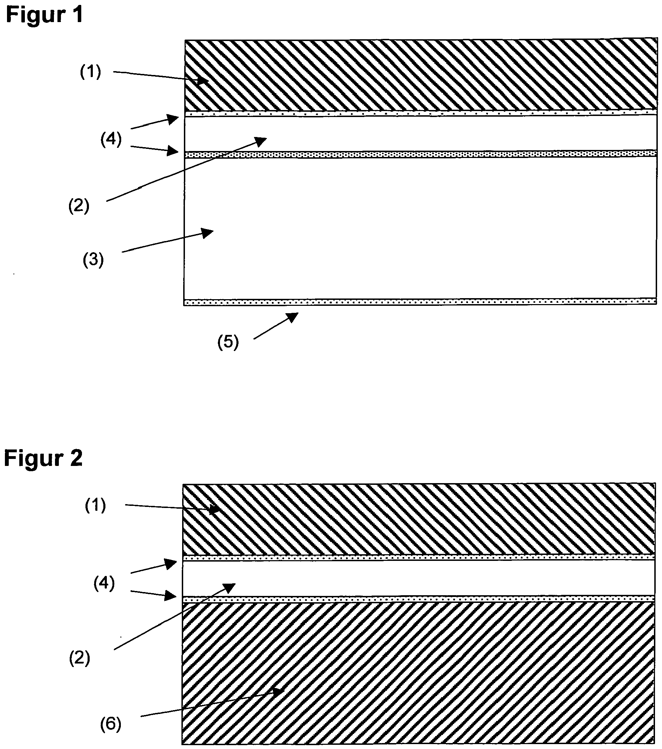

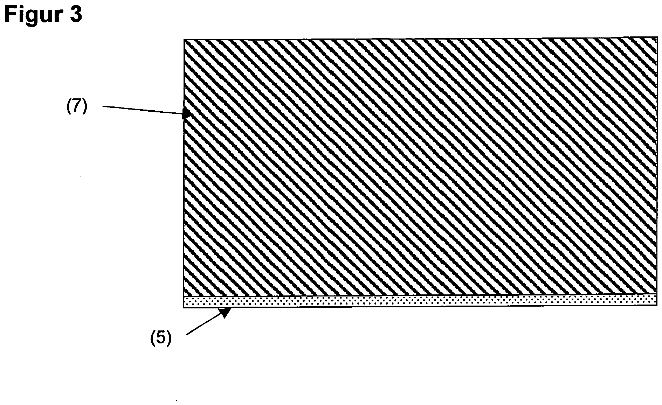

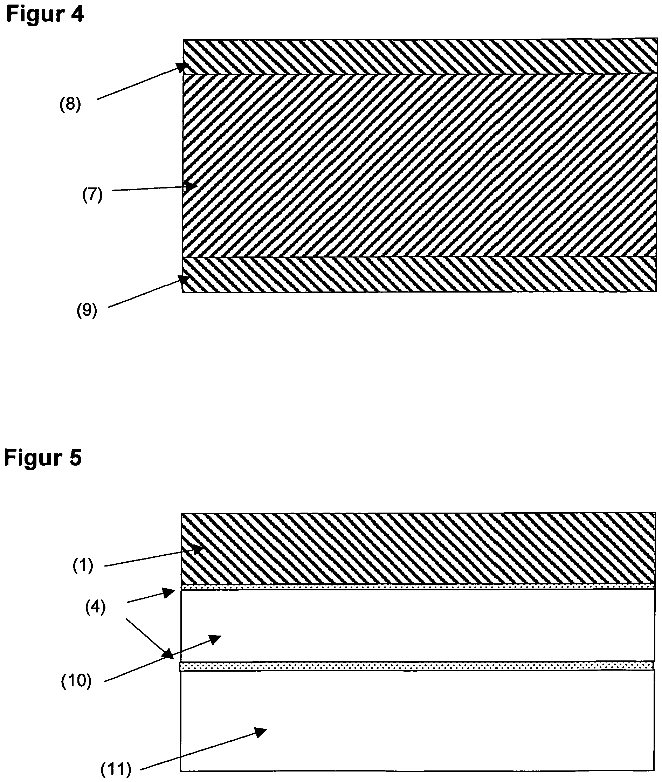

Typische Laminate sind in den Figuren 1 bis 5 dargestellt.

Dabei zeigt Figur 1 ein Laminat mit einer 50 $\mu$m dicken erfindungsgemäßen Folie (1) aus Beispiel 1, einer 12 $\mu$m dicken SiO$_x$ bedampften Polyesterfolie (2), die z. B. als X-Barrier®-Folie von Mitsubishi Plastics erhältlich ist, und einer weiteren 100 $\mu$m dicken weißen Polyesterfolie (3), die z. B. als Hostaphan® WDW/WUV- oder Hostaphan® WO/UVO-Folie von Mitsubishi Polyester Film GmbH erhältlich ist. Die einzelnen Folien werden mit jeweils einer Kleberschicht (4) zusammengehalten, und auf die freie Deckschicht der weißen Folie (3) ist eine weitere Kleberschicht (5) zur Haftvermittlung gegenüber dem Einkapselungsmedium (typischerweise EVA) der Solarzelle aufgebracht.

Figur 2 zeigt das Laminat aus Figur 1, jedoch ohne Kleberschicht (5); des weiteren ist die weiße Folie (3) durch eine erfindungsgemäße weiße Folie (6) aus Beispiel 2 ersetzt.

Figur 3 zeigt eine Ausführungsform, bei der allein eine erfindungsgemäße Folie (7) aus Beispiel 3 in einer Dicke von 275 $\mu$m mit aufgebrachter Kleberschicht (5) als Rückseitenisolation einer Solarzelle zum Einsatz kommt.

Figur 4 zeigt den Schichtaufbau der erfindungsgemäßen Folie aus Beispiel 4 mit der Basisschicht (7), der Deckschicht (8) und der Deckschicht (9). Die beiden Deckschichten (8) und (9) sind identisch und jeweils 10 $\mu$m dick, und die Basisschicht besitzt eine Dicke von 255 $\mu$m.

Figur 5 zeigt ein Laminat mit einer 50 $\mu$m dicken erfindungsgemäßen Folie (1) aus Beispiel 1, einer 150 $\mu$m dicken Polyesterfolie (10), die z. B. als Hostaphan® RN 100-Folie von Mitsubishi Polyester Film GmbH, Wiesbaden (Deutschland), erhältlich ist, und einer weiteren 150 $\mu$m dicken weißen Polyethylen- oder Polyesterfolie (11). Die einzelnen Folien werden mit jeweils einer Kleberschicht (4) zusammengehalten.

Die erfindungsgemäßen Polyesterfolien sowie die in den Laminaten enthaltenen anderen Folien werden über geeignete Klebstoffe verbunden, die sowohl aus Lösungen als auch als Hotmelt auf die erfindungsgemäße Folie oder auf die jeweilige andere Folie aufgetragen werden. Die Folien werden dann zwischen zwei Walzen zu einem Verbund verklebt. Geeignete Kleber müssen entsprechend dem jeweiligen Folientyp ausgewählt werden. Als geeignet haben sich Polyester-basierte Kleber, Acrylate und andere industrieübliche Klebersysteme erwiesen. Bevorzugt werden Kleber auf Polyurethan-Basis eingesetzt. Dabei sind Zweikomponenten-Klebesysteme besonders bevorzugt. Diese bestehen aus Polyurethan-Präpolymeren mit Isocyanat-Endgruppen, die mit polyfunktionellen Alkoholen vernetzt werden können. Die Isocyanat-Endgruppen können dabei entweder aromatischer Natur, wie z. B. Diphenylmethandiisocyanat (MDI) oder Toluendiisocyanat (TDI), oder aliphatischer Natur, wie z. B. Hexamthylendiisocyanat (HDI) oder Isophorondiisoyanat (IPDI), sein. Die oben genannten Komponenten werden mit einem Überschuss an Isocyanat-Gruppen zusammen mit weiteren Komponenten wie Stabilisatoren, Pigmenten u. a. sowie organischen Lösungsmitteln gemischt, um die erforderlichen Eigenschaften wie beispielsweise Klebrigkeit, Trockenheit der Kleber-Oberfläche, Festkörpergehalt sowie Farbeinstellung zu erhalten. Die Klebermischung kann entweder bei Raumtemperatur oder bei erhöhter Temperatur aushärten. Die Oberfläche der Trägerschicht oder/und die Oberflächen der Gegenseite können zur Erzeugung einer optimalen Klebverbindung physikalisch vorbehandelt werden. Geeignete Verfahren sind sowohl die Coronavorbehandlung als auch eine Flammbehandlung sowie eine Plasmavorbehandlung. Die Coronabehandlung wird bevorzugt angewandt, wobei eine partielle Oxidation erfolgt, die eine erhöhte Polarität der Oberfläche des Materials zur Folge hat.

Das so hergestellte Laminat oder die Einzellage aus erfindungemäßer Folie muss dann noch bei der Herstellung des Solarmoduls mit dem Einbettungsmaterial der Solarzellen verbunden werden. Das in der industriellen Praxis am häufigsten verwendete Einbettungsmaterial ist Ethylenvinylacetat (EVA), daneben kommen weitere Materialien wie Polymethylmetacrylat (PMMA), Polyvinylbuyral (PVB) und viele andere vor.

Zur Verbindung mit den Einbettmaterialien können prinzipiell die gleichen Isocyanatkleber benutzt werden wie zum Verkleben der Laminatlagen. Wenn die erfindungsgemäßen Folien die Außenlage zum Einbettungsmedium der Zellen hin (wie oben beschrieben, in der Regel EVA) darstellen, kann in der Regel auf Kleber verzichtet werden, da überraschenderweise die erfindungsgemäßen Folien bereits gute Hafteigenschaften zu den üblichen Einbettungsmaterialien (insbesondere zu EVA und PVB) aufweisen. Eine physikalische Vorbehandlung wie oben beschrieben verbessert die Haftung zusätzlich. Die Haftung zu den Einbettmedien kann auch durch Aufbringen einer Beschichtung verbessert werden. Hierbei hat sich wiederum das In-line-Beschichten während des Folienherstellungsprozesses nach der Längsstreckung und vor der Querstreckung als besonders wirtschaftlich erwiesen, da kein zusätzlicher Arbeitsgang erforderlich ist.

Diese Beschichtung sollte eine ausgezeichnete Dauerbeständigkeit gegen Feuchtigkeit und erhöhte Temperatur aufweisen, um sich zur Verwendung als Rückseitenabdeckung in Solarmodulen zu eignen. Sie sollte eine gute mechanische Widerstandsfähigkeit haben, um die im Folienherstellungsprozess, der Auf- und Abwicklung der Folie sowie bei der Herstellung der Solarmodule auftretenden Belastungen unbeschadet zu überstehen.

In einer bevorzugten Ausführungsform wird auf die erfindungsgemäße Folie als Haftvermittler eine Beschichtung, bestehend aus einem Polyurethan und einem Vernetzer, aufgebracht, wie es beispielsweise beschrieben ist in der WO 2010/094443.

Wenn Polyethylen (PE)- oder Polypropylenfolien (PP) als Laminatbestandteile verwendet werden, kann in der Regel auf Kleber verzichtet werden. Auch hier ist eine physikalische Vorbehandlung wie oben beschrieben vorteilhaft.

Die erfindungsgemäße Folie bzw. das Laminat, welches diese Folie beinhaltet, wird bei der Herstellung der Solarmodule auf das Einbettungsmedium aufgebracht und nach bekannten Verfahren mit diesem verpresst.

In den nachfolgenden Ausführungsbeispielen erfolgt die Messung der einzelnen Eigenschaften gemäß den angeführten Normen bzw. Verfahren.

**Messmethoden**

**Standardviskosität (SV)**

Die Standardviskosität SV wird - angelehnt an DIN 53726 - durch die Messung der relativen Viskosität $\eta_{rel.}$ einer 1 Gew.-%igen Lösung in Dichloressigsäure (DCE) in einem Ubbelohde Viskosimeter bei 25 °C gemessen. Aus der relativen Viskosität $\eta_{rel.}$ wird der dimensionslose SV-Wert wie folgt ermittelt:

$$SV = (\eta_{rel.} - 1) \bullet 1000$$

Folie bzw. Polymerrohstoffe werden dazu in DCE gelöst, und die Weißpigmente werden vor der Messung abzentrifugiert. Der Anteil an Pigmenten wird mittels Aschebestimmung ermittelt und durch entsprechende Mehreinwaage korrigiert. D. h. Einwaage = (Einwagemenge laut Vorschrift) / ((100-Partikelgehalt in %)/100).

**Schrumpf**

Der thermische Schrumpf wird an quadratischen Folienmustern mit einer Kantenlänge von 10 cm bestimmt. Die Proben werden so ausgeschnitten, dass eine Kante parallel zur Maschinenrichtung und eine Kante senkrecht zur Maschinenrichtung verläuft. Die Proben werden genau ausgemessen (die Kantenlänge $L_0$ wird für jede Maschinenrich-tung TD und MD bestimmt, $L_{0\,TD}$ und $L_{0\,MD}$) und werden 15 min bei der angegeben Schrumpfungstemperatur (hier 150 °C) in einem Umlufttrockenschrank getempert. Die Proben werden entnommen und bei Raumtemperatur genau ausgemessen (Kantenlänge $L_{TD}$ und $L_{MD}$). Der Schrumpf ergibt sich aus der Gleichung

$$\text{Schrumpf [\%] MD} = 100 \bullet (L_{0\,MD} - L_{MD}) / L_{0\,MD}$$

$$\text{Schrumpf [\%] TD} = 100 \bullet (L_{0\,TD} - L_{TD}) / L_{0\,TD}$$

**Messung der Transparenz bei 370 nm**

Die Messung der Transparenz erfolgt mit einem Lambda 3 UV/Vis Spektrometer der Firma Perkin Elmer.

**Messung der Spannungsfestigkeit / Durchschlagfestigkeit (BDV)**

Die Messung der Spannungsfestigkeit erfolgt gemäß DIN 53481-3 (unter Berücksichtigung von DIN 40634 für die speziellen Folienanweisungen). Es wird mittels Kugel/Platte (Elektrodendurchmesser 49,5 mm) bei einer sinusförmigen Wechselspannung von 50 Hz bei 21 °C und 50 rel. Luftfeuchte in Luft gemessen.

**Messung der Teilentladungsfestigkeit (PDV)**

Die PDV wird nach IEC 60664-1 bestimmt

**Messung des mittleren Partikeldurchmessers $d_{50}$**

Die Bestimmung des mittleren Partikeldurchmessers $d_{50}$ wird mittels Laser auf einem Master Sizer (Malvern Instruments, UK) nach der Standardmethode durchgeführt (andere Messgeräte sind z. B. Horiba LA 500 (Horiba Ltd., Japan) oder Helos (Sympatec GmbH, Deutschland), welche das gleiche Messprinzip verwenden). Die Proben werden dazu in eine Küvette mit Wasser gegeben und diese dann in das Messgerät gestellt. Der Messvorgang ist automatisch und beinhaltet auch die mathematische Bestimmung des $d_{50}$-Wertes. Der $d_{50}$-Wert wird dabei definitionsgemäß aus der (relativen) Summenkurve der Partikelgrößenverteilung bestimmt: Der Schnittpunkt des 50 %-Ordinatenwertes mit der Summenkurve liefert auf der Abszissenachse den gewünschten $d_{50}$-Wert.

**Messung der mechanischen Eigenschaften der Folie**

Die Bestimmung der mechanischen Eigenschaften erfolgt nach DIN EN ISO 527-1 bis 3.

**Autoklavierung**

Die Folien (10 • 2 cm) werden an einem Draht in den Autoklaven (Adolf Wolf SANOklav Typ: ST-MCS-204) gehängt und der Autoklav mit 2 l Wasser befüllt. Nach dem Schließen des Autoklaven wird dieser erhitzt. Bei 100 °C wird die Luft durch den Wasserdampf über das Ablassventil verdrängt. Dies wird nach ca. 5 min geschlossen, worauf die Temperatur auf 110 °C und der Druck auf 1,2 - 1,5 bar ansteigt. Nach der eingestellten Zeit (mind. 12 h) wird der Autoklav automatisch abgeschaltet, und nach Öffnen des Ablassventils werden die Folien entnommen. An diesen wird dann der SV-Wert bestimmt.

**Weißgrad**

Der Weißgrad wird nach Berger bestimmt. Die Untersuchung wird mit einem Farbmessgerät "color sphere" (Spektralphotometer; Fa. BYK Gardner, Deutschland) durchgeführt, an das ein Rechner angeschlossen ist, der die Auswertung der Messwerte übernimmt. Das Farbmesssystem besteht aus einem Spektralphotometer mit Ulbricht-Kugel und einer d/8°-Messgeometrie (Doppelstrahl). Die Probe wird vom Messstrahl in Abständen von 20 nm mit einer Silizium-Fotozelle / Interferenzfilter abgetastet (Messbereich 400 - 700 nm). Der angeschlossene Rechner ruft das Programm Auto QC zur Messung auf und steuert den Ablauf der Messung (Software von Fa. BYK Gardner mitgeliefert). Die Messung erfolgt an einer Folienlage, wobei über die zu messende Folie eine Lichtfalle (Schwarzer Tubus als Zubehör zum Farbmessgerät "color sphere" von Fa. BYK Gardner erhältlich) gelegt wird.

**Transparenz**

Die Transparenz wird nach ASTM-D 1003 mittels haze-gard plus der Firma BYK-Gardner GmbH, Deutschland, ohne Kompensation gemessen.

**Beispiele**

Verfahren: Die Rohstoffe wurden gemischt und in einem Zweischneckenextruder der Firma Japan Steel Works mit Entgasung extrudiert. In den Extruderzonen und in der Schmelzeleitung betrug die Temperatur maximal 275 °C. Der Durchsatz betrug 2000 kg pro Stunde. Die Schmelze wurde durch eine Breitschlitzdüse (Temperatur 275 °C) auf eine Kühlwalze (30 °C) extrudiert und anschließend bei 105 °C um den Faktor 3,2 in Längsrichtung gestreckt und dann bei 110 °C um den Faktor 3,2 in Querrichtung gestreckt.
Die Folie wurde dann bei 222 °C fixiert, wobei im letzten Feld 2 % Relaxation in Querrichtung eingestellt wurden. In den beiden folgenden Fixierfeldern waren 190 °C und 150 °C eingestellt, und die Relaxation hier betrug weitere 3 %. Die Gesamtverweilzeit in der Fixierung betrug 15 s.

Verwendete Rohstoffe:

R1 = Polycyclohexandimethanol-terephthalat-isophthalat, Typ Durastar DS2000 (Hersteller Eastman, USA), SV = 980, IPA-Gehalt ca. 26 Mol-%, TA-Gehalt ca. 74 Mol-%

R2 = Polycyclohexandimethanol-terephthalat-isophthalat, Typ Eastar A150 (Hersteller Eastman, USA), SV = 1100, IPA-Gehalt ca. 17 Mol-% , TA-Gehalt ca. 83 Mol-%

R3 = Rohstoff R1 mit 20 Gew.-% $TiO_2$ TiPure R-105 von DuPont (USA), kompoundiert in einem Zweischneckenextruder der Firma Japan Steel Works mit Entgasung, SV = 880

R4 = Rohstoff R2 mit 20 Gew.-% $TiO_2$ TiPure R-105 von DuPont (USA), kompoundiert in einem Zweischneckenextruder der Firma Japan Steel Works mit Entgasung, SV = 980

R5 = Rohstoff R1 mit 10 Gew.-% Tinuvin 1577 (Hersteller BASF, ehemals Ciba SC, Schweiz), kompoundiert in einem Zweischneckenextruder der Firma Japan Steel Works mit Entgasung, SV = 870

(fortgesetzt)

R6 = Rohstoff R1 mit 10 % Cyasorb-ZV-3529 (Hersteller Cytec, USA), kompoundiert in einem Zweischneckenextruder der Firma Japan Steel Works mit Entgasung, SV = 870

R7 = PETG Typ Eastar 6763 (Hersteller Eastman, USA), SV = 1045, TA-Gehalt 100 Mol-%, Ethylenglykol-Gehalt ca. 69 Mol-%, Cyclohexandi-methanol-Gehalt ca. 31 Mol-%

Die Rohstoffzusammensetzung der einzelnen Schichten sowie die resultierenden Folieneigenschaften können der Tabelle 1 entnommen werden.

Tabelle 1

| Eigenschaft | | Beispiel | | | | Vergleichsbeispiel | | |
|---|---|---|---|---|---|---|---|---|
| | | 1 | 2 | 3 | 4 | 1 | 2 | 3 |
| Rohstoffe (für Monoschicht in Beispiel 1-3 und Basisschicht im Fall von Beispiel 4) | R1 | 75 Gew.-% | 75 Gew.-% | 75 Gew.-% | 75 Gew.-% | | | 100 Gew.% |
| | R2 | | | | | | 75 Gew.-% | |
| | R3 | 25 Gew.-% | 25 Gew.-% | 25 Gew.-% | 25 Gew.-% | | | |
| | R4 | | | | | | 25 Gew.-% | |
| | R7 | | | | | 100 Gew.-% | | |
| Rohstoffe (Coexschichten A/A' in Beispiel 4) | R1 | | | | 55 Gew.-% | | | |
| | R4 | | | | 25 Gew.-% | | | |
| | R5 | | | | 10 Gew.-% | | | |
| | R6 | | | | 10 Gew.% | | | |
| Gesamtdicke | in $\mu$m | 50 | 100 | 275 | 275 | 50 | 275 | 275 |
| SV-Wert der Folie direkt nach Produktion | - | 896 | 906 | 910 | 900 | 919 | 980 | 930 |
| Hydrolysegeschwindigkeit nach 144 h im Autoklaven | in SV/h | -0,70 | -0,74 | -0,83 | -0,88 | -4,1 | -0,83 | -0,71 |
| Schrumpf, längs | in% | 1,5 | 1,7 | 1,7 | 1,7 | | 1,7 | 1,8 |
| Schrumpf, quer | in% | 0,0 | 0,1 | -0,1 | -0,1 | | -0,1 | 0,0 |
| E-Modul, längs | in N/mm$^2$ | 2700 | 2600 | 2500 | 2500 | | 2800 | 2600 |
| E-Modul, quer | in N/mm$^2$ | 2700 | 2600 | 2600 | 2500 | | 2900 | 2600 |
| Kraft bei 5% Dehnung, längs | in N/mm$^2$ | 77 | 73 | 69 | 70 | | 80 | 72 |
| Kraft bei 5% Dehnung, quer | in N/mm$^2$ | 76 | 72 | 70 | 69 | | 78 | 70 |
| Reißfestigkeit, längs | in N/mm$^2$ | 107 | 110 | 86 | 87 | | 115 | 105 |
| Reißfestigkeit, quer | in N/mm$^2$ | 108 | 109 | 83 | 86 | | 115 | 107 |
| Reißdehnung, längs | in % | 99 | 102 | 85 | 86 | | 70 | 93 |

(fortgesetzt)

| Eigenschaft | | Beispiel | | | | Vergleichsbeispiel | | |
|---|---|---|---|---|---|---|---|---|
| | | 1 | 2 | 3 | 4 | 1 | 2 | 3 |
| Reißdehnung, quer | in % | 100 | 101 | 82 | 85 | | 73 | 91 |
| Spannungsfestigkeit / Durchschlagfestigkeit (BDV) | in V/µm | 251 | 215 | 194 | 199 | | 195 | 196 |
| Teilentladungsfestigkeit (PDV) | in V | 376 | 453 | 906 | 906 | | 904 | 1005 |
| Weißgrad | - | | 90 | 96 | 97 | | 98 | Nicht messbar |
| Transparenz | in % | | 24 | 11 | 9 | | 10 | 92 |
| Kommentar | | | | | | 1.) | 2.) | 3.) |

1.) Hydrolysegeschwindigkeit zu hoch
2.) Anteil der 2. Dicarbonsäurekomponente ist kleiner als die erfindungsgemäßen 18 % und führte im Vergleich zu Beispiel 3 zu mehr als 3 mal so vielen Abrissen bei der Herstellung, was im Wesentlichen auf Versprödung im Randbereich zurückzuführen war.
3.) Bei Verwendung als Backsheet im Beispiellaminat 3 ergibt sich gegenüber der Verwendung der Folie aus Beispiel 3 ein geringerer Wirkungsgrad des Solarmoduls aufgrund der geringeren Reflektion der Folie.

**Patentansprüche**

1. Weiße, biaxial gestreckte Folie, überwiegend bestehend aus einem Polyester, dessen

   - Diolkomponente zu mindestens 80 Mol-% aus 1,4-Cyclohexandimethanol (CHDM) besteht und dessen
   - Dicarbonsäurekomponente zu mindestens 80 Mol-% aus einer oder mehreren Benzoldicarbonsäure(n) oder/und einer oder mehreren Naphthalindicarbonsäure(n) besteht, die Dicarbonsäurekomponente aus einer

   o Hauptdicarbonsäurekomponente mit mindestens 55 Mol-% Anteil besteht, die ausgewählt ist aus einer der beiden Dicarbonsäuren 2,6-Naphthalindicarbonsäure und Terephthalsäure, und aus einer
   o Nebendicarbonsäurekomponente mit mindestens 18 Mol-% Anteil besteht, wobei die Nebendicarbonsäurekomponente verschieden ist von der Hauptdicarbonsäurekomponente.

2. Folie nach Anspruch 1, **dadurch gekennzeichnet, dass** die Dicarbonsäurekomponente aus einer oder mehreren Benzoldicarbonsäure(n) besteht.

3. Folie nach Anspruch 1 oder 2, **dadurch gekennzeichnet, dass** die Naphthalindicarbonsäure 2,6-Naphthalindicarbonsäure (2,6-NDC) ist und die Benzoldicarbonsäure Terephthalsäure (= TA) ist.

4. Folie nach Anspruch 1, 2 oder 3, **dadurch gekennzeichnet, dass** die Hauptdicarbonsäurekomponente Terephthalsäure ist.

5. Folie nach einem der Ansprüche 1 bis 4, **dadurch gekennzeichnet, dass** die Nebendicarbonsäurekomponente

   - 2,6-Naphthalindicarbonsäure ist, wenn die Hauptdicarbonsäurekomponente Terephthalsäure ist, und
   - Terephthalsäure ist, wenn die Hauptdicarbonsäurekomponente 2,6-Naphthalindicarbonsäure ist.

6. Folie nach einem der Ansprüche 1 bis 4, **dadurch gekennzeichnet, dass** die Nebendicarbonsäurekomponente Isophthalsäure (IPA) ist.

7. Folie nach einem der Ansprüche 1 bis 6, **dadurch gekennzeichnet, dass** die Nebendicarbonsäurekomponente einen Anteil von mindestens 20 Mol-%, bevorzugt mindestens 25 Mol-%, hat.

8. Folie nach einem der Ansprüche 1 bis 7, **dadurch gekennzeichnet, dass** die Folie Weißpigmente enthält, bevorzugt solche, ausgewählt aus der Gruppe:

   Titandioxid, Bariumsulfat, Zinkoxid, Kalziumkarbonat, inkompatible Polymere und Kombinationen aus diesen Weißpigmenten, wobei die Weißpigmente in der Folie besonders bevorzugt in einer Menge von 1 - 30 Gew.-% (bezogen auf das Gesamtgewicht der Folie) vorhanden sind und ganz besonders bevorzugt eine Teilchengröße ($d_{50}$) von 0,05 bis 5 $\mu$m aufweisen.

9. Folie nach Anspruch 8, **dadurch gekennzeichnet, dass** das Weißpigment $TiO_2$ ist, welches bevorzugt anorganisch beschichtet und gegebenenfalls zusätzlich organisch beschichtet ist, wobei die bevorzugten anorganischen Beschichtungen $SiO_2$ und/oder $Al_2O_3$ und besonders bevorzugt Kombinationen aus $SiO_2$ und $Al_2O_3$ sind.

10. Folie nach einem der Ansprüche 1 bis 9, **dadurch gekennzeichnet, dass** die Foliendicke zwischen 12 und 600 $\mu$m liegt.

11. Folie nach einem der Ansprüche 1 bis 10, **dadurch gekennzeichnet, dass** der Weißgrad nach Berger größer oder gleich 40 ist und/oder die Transparenz der Folie kleiner als 50 % ist.

12. Biaxial orientierte weiße Polyesterfolie, **gekennzeichnet durch**

    - einen Weißgrad nach Berger von größer oder gleich 40 und
    - eine Transparenz von < 50 % und
    - eine Transparenz im UV-A-Bereich bei 370 nm von < 10 % und
    - einen E-Modul in jeder Folienrichtung von größer 1500 N/mm$^2$, aber in keiner Folienrichtung einen E-Modul von größer 5000 N/mm$^2$, und
    - einen F5-Wert (Kraft bei 5 % Dehnung) in jeder Folienrichtung von größer 40 N/mm$^2$, aber in keiner Folienrichtung eine Kraft bei 5 % Dehnung von größer 140 N/mm$^2$, und
    - eine Reißfestigkeit in jeder Folienrichtung von größer 65 N/mm$^2$, aber in keiner Folienrichtung von größer 290 N/mm$^2$, und
    - einen Schrumpf bei 150 °C (15 min) in beiden Folienrichtungen von kleiner als 3 %, aber in keiner Folienrichtung von < -1,0 % (entspricht 1 % Dehnung),
    - eine Spannungsfestigkeit (BDV) (50 Hz, 21 °C, 50 rel. Luftfeuchte, gemessen in Luft) von mindestens 40 V/$\mu$m und eine Teilentladungsfestigkeit (PDV) der nachfolgenden Gleichung:

    $$\text{PDV [V]} = x \text{ [V/}\mu\text{m]} \cdot \text{Foliendicke [}\mu\text{m]} + y \text{ [V]}$$

    mit einem x-Wert von > 0,75[V/$\mu$m] und einem y-Wert von > 100[V] und
    - eine SV-Wert-Abbaugeschwindigkeit von > -3 SV-E/h (SV-E = SV-Einheit).

13. Verfahren zur Herstellung einer Folie nach Anspruch 1, wobei man eine oder mehrere gleiche oder verschiedene Polymerschmelzen durch eine Flachdüse extrudiert, zur Verfestigung auf einer oder mehreren Walze(n) als weitgehend amorphe Vorfolie abzieht und abschreckt, diese Vorfolie anschließend erneut erhitzt und biaxial streckt (orientiert) und die biaxial gestreckte Folie thermofixiert und anschließend aufrollt, **dadurch gekennzeichnet, dass** das Polymer aus einem Polyester besteht, dessen

    - Diolkomponente zu mindestens 80 Mol-% aus 1,4-Cyclohexandimethanol (CHDM) besteht und dessen
    - Dicarbonsäurekomponente zu mindestens 80 Mol-% aus einer oder mehreren Benzoldicarbonsäure(n) oder/und einer oder mehreren Naphthalindicarbonsäure(n) besteht, wobei die Dicarbonsäurekomponente aus einer

      o Hauptdicarbonsäurekomponente mit mindestens 55 Mol-% Anteil besteht, die ausgewählt ist aus einer der beiden Dicarbonsäuren 2,6-Naphthalindicarbonsäure und Terephthalsäure, und aus einer
      o Nebendicarbonsäurekomponente mit mindestens 18 Mol-% Anteil besteht, wobei die Nebendicarbonsäurekomponente verschieden ist von der Hauptdicarbonsäurekomponente.

14. Verwendung einer Folie nach Anspruch 1 oder 12 für Elektroisolieranwendungen, insbesondere für Flachbandkabel in Automobilen, Kabel in Sitzheizungen und als Motorisolation.

15. Verwendung einer Folie nach Anspruch 1 oder 12 für die Rückseitenisolation in Solarmodulen.

# Figur 1

# Figur 2

**Figur 3**

(7)

(5)

# Figur 4

(8)

(7)

(9)

# Figur 5

(1)

(4)

(10)

(11)

**IN DER BESCHREIBUNG AUFGEFÜHRTE DOKUMENTE**

**In der Beschreibung aufgeführte Patentdokumente**

- US 3051212 A
- FR 2812299

- US 6737226 A
- WO 2010094443 A